(19) Europäisches Patentamt
European Patent Office
Office européen des brevets

(11) **EP 3 862 459 A1**

(12) **EUROPEAN PATENT APPLICATION**
published in accordance with Art. 153(4) EPC

(43) Date of publication:
**11.08.2021 Bulletin 2021/32**

(21) Application number: **18936160.3**

(22) Date of filing: **03.10.2018**

(51) Int Cl.:
**C23C 14/06** (2006.01)    **B32B 9/00** (2006.01)
**B32B 15/04** (2006.01)    **C03C 17/36** (2006.01)
**C23C 14/08** (2006.01)    **C23C 14/34** (2006.01)

(86) International application number:
**PCT/JP2018/037025**

(87) International publication number:
**WO 2020/070824 (09.04.2020 Gazette 2020/15)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Mitsubishi Materials Corporation
Tokyo 100-8117 (JP)**

(72) Inventors:
• **TOSHIMORI Yuto
Naka-shi, Ibaraki 311-0102 (JP)**
• **MATSUZAKI Hideharu
Sanda-shi, Hyogo 669-1339 (JP)**
• **SHIONO Ichiro
Sanda-shi, Hyogo 669-1339 (JP)**

(74) Representative: **Hoffmann Eitle
Patent- und Rechtsanwälte PartmbB
Arabellastraße 30
81925 München (DE)**

(54) **MULTILAYER FILM, AND AG ALLOY SPUTTERING TARGET**

(57)    A multilayer film (10) includes: an Ag alloy film (11); and a transparent dielectric film (12) laminated on both surfaces of the Ag alloy film (11), and in the Ag alloy film (11), at least one of Sn or Ge is contained in a range of 0.5 atom% to 8.0 atom% in total, a total content of Na, K, Ba, and Te is 50 ppm by mass or less, a carbon content is 50 ppm by mass or less, and a remainder contains Ag and unavoidable impurities.

FIG. 1

EP 3 862 459 A1

**Description**

TECHNICAL FIELD

The present invention relates to, for example, a multilayer film that can be used as a heat shield film of low-emission glass that reflects infrared rays to shield heat or as a transparent conductive wiring film of a display or a touch panel, and an Ag alloy sputtering target that is used in the formation of an Ag alloy film constituting the multilayer film.
Priority is claimed on Japanese Patent Application No. 2017-076938, filed April 7, 2017, the content of which is incorporated herein by reference.

BACKGROUND ART

In general, the above-described low-emission glass or the like has, for example, a structure in which a multilayer film (heat shield film) in which an Ag alloy film and a transparent dielectric film are laminated is formed on a glass surface as disclosed in Patent Literature 1. The multilayer film used in the low-emission glass or the like is required to have high infrared reflectance and high visible light transmittance.
Such a multilayer film is also used as, for example, a transparent conductive wiring film for various displays and the like as described in Patent Literature 2. The transparent conductive wiring film is required to have high light transmittance in a visible light region and low electrical resistance.
In the formation of an Ag alloy film on a glass substrate or the like, for example, a sputtering method using an Ag alloy sputtering target is used as disclosed in Patent Literatures 3 and 4.

[Citation List]

[Patent Literature]

[Patent Literature 1]
Japanese Unexamined Patent Application, First Publication No. 2007-070146
[Patent Literature 2]
Japanese Unexamined Patent Application, First Publication No. H09-232278
[Patent Literature 3]
Japanese Unexamined Patent Application, First Publication No. 2004-238648
[Patent Literature 4]
Japanese Unexamined Patent Application, First Publication No. 2006-240289

SUMMARY OF INVENTION

Technical Problem

In a case where the above-described multilayer film is used as a heat shield film, the film is required to have optical characteristics for transmitting visible light and reflecting infrared rays. In a case where the multilayer film is used as a transparent conductive wiring film, the film is required to have optical characteristics for transmitting visible light and electrical characteristics for obtaining an excellent conductivity.
For example, in the production of low-emission glass or the like, for the purpose of strengthening the glass, a heat treatment (air cooling strengthening method) including heating to, for example, 700°C and rapid cooling by air or the like may be performed in a state in which a multilayer film is formed. In the above-described multilayer film, the Ag alloy film may be cracked during the heat treatment. For this reason, a protective film such as a metal film is formed on both surfaces of the Ag alloy film to improve the durability of the Ag alloy film. However, due to the formation of the protective film, problems such as an increase of the production cost and a deterioration of the optical characteristics may occur.
In the production of a transparent conductive wiring film for various displays and the like, the process may also include the heat treatment.
The present invention is contrived in view of the above-described circumstances, and an object thereof is to provide a multilayer film having excellent heat resistance, optical characteristics, and electrical characteristics, and an Ag alloy sputtering target that is used in the formation of an Ag alloy film constituting the multilayer film.

Solution to Problem

In order to solve the problems, a multilayer film according to the present invention includes: an Ag alloy film; and a transparent dielectric film laminated on both surfaces of the Ag alloy film, and the Ag alloy film has a composition in which at least one of Sn or Ge is contained in a range of 0.5 atom% to 8.0 atom% in total, a total content of Na, K, Ba, and Te is 50 ppm by mass or less, a carbon content is 50 ppm by mass or less, and a remainder contains Ag and unavoidable impurities.

In the multilayer film according to the present invention, since the Ag alloy film contains at least one of Sn or Ge in a range of 0.5 atom% to 8.0 atom% in total, the heat resistance of the Ag alloy film can be improved. Accordingly, it is not required to form a protective film made of a metal.

Na, K, Ba, and Te are elements that have a relatively low melting point of 700°C or lower and are unlikely to be solid-soluted in Ag. Therefore, by limiting the total content of Na, K, Ba, and Te to 50 ppm by mass or less in the Ag alloy film, it is possible to suppress the concentration of the elements at grain boundaries due to a heat treatment or the like.

Carbon may be oxidized during the heat treatment and released as a CO gas or a $CO_2$ gas, that may cause unevenness in the Ag alloy film. Accordingly, by limiting the carbon content of the Ag alloy film to 50 ppm by mass or less, it is possible to suppress the occurrence of unevenness in the Ag alloy film due to the heat treatment or the like.

Therefore, in the multilayer film according to the present invention, even in a case where a heat treatment is performed under a relatively high temperature condition such as 700°C, it is possible to suppress the occurrence of cracks in the Ag alloy film.

In addition, the multilayer film according to the present invention is excellent in optical characteristics such as visible light transmittance and infrared reflectance, and is also excellent in electrical characteristics such as conductivity.

In the multilayer film according to the present invention, it is preferable that the Ag alloy film contains at least one of Sn or Ge in a range of 0.5 atom% to 3.0 atom% in total.

In this case, since the upper limit of the total content of at least one of Sn or Ge is 3.0 atom% or less, it is possible to further improve the optical characteristics and the electrical characteristics of the multilayer film.

In the multilayer film according to the present invention, the Ag alloy film further contains at least one additive element selected from Mg, Ca, and Sb, a total content of the additive element is represented by X atom%, and a total content of Sn and Ge is represented by Z atom%. In this case, it is preferable that the ratio X/Z is in a range of $0.02 \leq X/Z \leq 0.4$.

Since the Ag alloy film contains Mg, Ca, and Sb in the above range, the heat resistance of the Ag alloy film can be further improved.

In the multilayer film according to the present invention, it is preferable that the transparent dielectric film is an oxide film or a nitride film containing at least one selected from Zn, Al, Sn, Ti, Si, Zr, Ta, and In.

In this case, the transparent dielectric film is excellent in optical characteristics such as visible light transmittance and electrical characteristics, and the optical characteristics and the electrical characteristics of the multilayer film can be improved.

An Ag alloy sputtering target according to the present invention has a composition in which at least one of Sn or Ge is contained in a range of 0.5 atom% to 8.0 atom% in total, a total content of Na, K, Ba, and Te is 50 ppm by mass or less, a carbon content is 50 ppm by mass or less, and a remainder contains Ag and unavoidable impurities. As described above, with the Ag alloy sputtering target having the above configuration, it is possible to form an Ag alloy film having excellent heat resistance, optical characteristics, and electrical characteristics.

In the Ag alloy sputtering target according to the present invention, it is preferable that at least one of Sn or Ge is contained in a range of 0.5 atom% to 3.0 atom% in total.

In this case, since the upper limit of the total content of at least one of Sn or Ge is 3.0 atom% or less, it is possible to form an Ag alloy film that is more excellent in optical characteristics and electrical characteristics of a multilayer film.

In the Ag alloy sputtering target according to the present invention, it is preferable that at least one additive element selected from Mg, Ca, and Sb is further contained, and in a case where a total content of the additive element is represented by X atom% and a total content of Sn and Ge is represented by Z atom%, a ratio X/Z is in a range of $0.02 \leq X/Z \leq 0.4$.

Since Mg, Ca, and Sb are contained in the above range, the heat resistance of an Ag alloy film formed can be further improved.

In the Ag alloy sputtering target according to the present invention, it is preferable that an area of a sputtering surface is 0.25 $m^2$ or greater, an average crystal grain size $\mu_{GS}$ in the sputtering surface is 200 $\mu m$ or less, and a distribution $D_{GS}$ defined by the following expression by a standard deviation $\sigma_{GS}$ of the crystal grain size and the average crystal grain size $\mu_{GS}$ is 25% or less.

**EP 3 862 459 A1**

$$D_{GS} = (\sigma_{GS}/\mu_{GS}) \times 100 \ (\%)$$

In this case, even in a case where the area of the sputtering surface is a large area of 0.25 m² or greater, the average crystal grain size $\mu_{GS}$ in the sputtering surface is 200 $\mu$m or less, and thus it is possible to suppress the occurrence of abnormal discharge during sputtering. In addition, since the distribution $D_{GS}$ defined by the standard deviation $\sigma_{GS}$ of the crystal grain size and the average crystal grain size $\mu_{GS}$ is 25% or less, it is possible to suppress variations in sputtering rate in the sputtering surface even after the sputtering has proceeded, and it is possible to form an Ag alloy film with little variation in thickness.

ADVANTAGEOUS EFFECTS OF INVENTION

It is possible to provide a multilayer film having excellent heat resistance, optical characteristics, and electrical characteristics, and an Ag alloy sputtering target that is used in the formation of an Ag alloy film constituting the multilayer film.

BRIEF DESCRIPTION OF DRAWINGS

Fig. 1 is a cross-sectional view illustrating a multilayer film according to an embodiment of the present invention.
Fig. 2 is an illustration showing positions where a crystal grain size is measured in a sputtering surface of an Ag alloy sputtering target according to the embodiment of the present invention.
Fig. 3A is a photograph showing an observation result of the appearance of a multilayer film of Invention Example 3 after a heat treatment in Examples.
Fig. 3B is a photograph showing an observation result of the appearance of a multilayer film of Comparative Example 1 after a heat treatment in Examples.

DESCRIPTION OF EMBODIMENTS

Hereinafter, a multilayer film and an Ag alloy sputtering target according to one embodiment of this invention will be described. The multilayer film according to this embodiment is formed on a surface of a glass substrate, and constitutes low-emission glass that reflects infrared rays to shield heat.

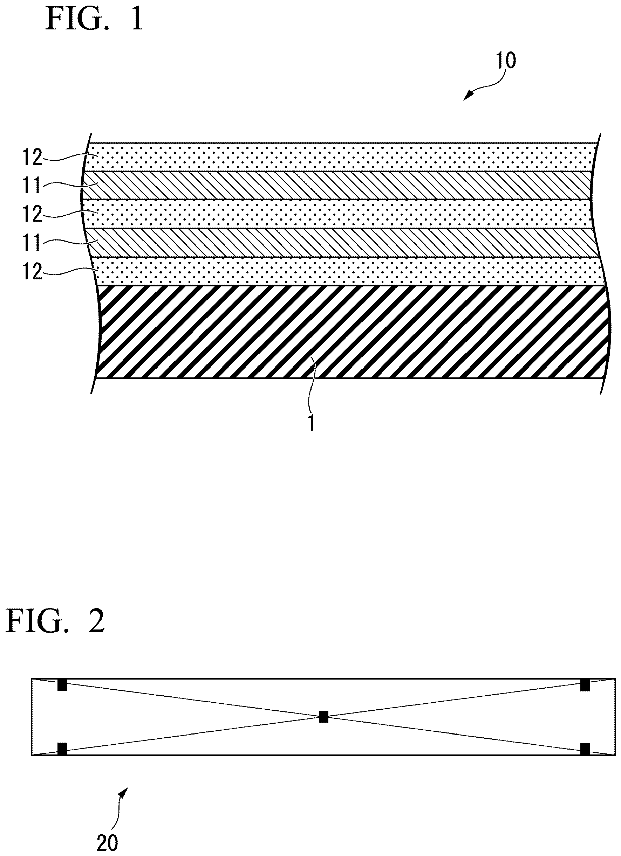

As shown in Fig. 1, a multilayer film 10 according to this embodiment is formed on a surface of a glass substrate 1, and includes Ag alloy films 11 and transparent dielectric films 12 formed on both surfaces of the Ag alloy film 11. The multilayer film 10 according to this embodiment has a structure of (2n+1) layers (n is the number of Ag alloy films 11). In this embodiment, two Ag alloy films 11 are formed, and the entire structure is a five-layer structure.

The film thickness of each Ag alloy film 11 is, for example, in a range of 5 nm to 30 nm.

The film thickness of each transparent dielectric film 12 is, for example, in a range of 5 nm to 200 nm.

It is preferable that the transparent dielectric film 12 functions as an optical adjustment layer, and is formed of an oxide film or a nitride film containing at least one selected from Zn, Al, Sn, Ti, Si, Zr, Ta, and In. Specific examples thereof include $ZnO_X$, $SnO_X$, $ZnSnO_X$, $AlO_X$, $AlN_X$, $TiO_X$, $SiN_X$, $ZrO_X$, $TaO_X$, and $InSnO_X$.

The oxide film or the nitride film is preferably appropriately selected according to required characteristics.

The Ag alloy film 11 has a composition in which at least one of Sn or Ge is contained in a range of 0.5 atom% to 8.0 atom% in total, a total content of Na, K, Ba, and Te is 50 ppm by mass or less, a carbon content is 50 ppm by mass or less, and a remainder contains Ag and unavoidable impurities. The Ag alloy film 11 according to this embodiment preferably contains at least one of Sn or Ge in a range of 0.5 atom% to 3.0 atom% in total.

It is preferable that the Ag alloy film 11 further contains at least one additive element selected from Mg, Ca, and Sb, and in a case where a total content of the additive element is represented by X atom% and a total content of Sn and Ge is represented by Z atom%, a ratio X/Z is in a range of $0.02 \leq X/Z \leq 0.4$.

A noble metal (Au, Pt, Pd, Rh, Ir, Ru, Os) may be further appropriately added to the Ag alloy film 11.

The Ag alloy film 11 according to this embodiment is formed by a sputtering method using an Ag alloy sputtering target 20.

The Ag alloy sputtering target 20 has the same composition as the above-described Ag alloy film 11. From the result of the component analysis of the formed Ag alloy film 11 by ICP emission spectroscopic analysis, the Ag alloy film is confirmed to have a composition substantially equivalent to that of the Ag alloy sputtering target 20.

The reasons why the compositions of the Ag alloy film 11 and the Ag alloy sputtering target 20 are specified as described above will be shown below.

4

(At Least One of Sn or Ge)

Sn or Ge is an element that exists at crystal grain boundaries or in grains of the Ag film during heating of the film and suppresses the movement and aggregation of Ag atoms due to heat by a pinning effect, thereby improving the heat resistance of the Ag alloy film 11. It is possible to suppress the occurrence of defects such as cracks in the Ag alloy film 11 even in a case where the Ag alloy film 11 is heat-treated under a relatively high temperature condition such as 700°C. In addition, it is possible to improve the optical characteristics and the electrical characteristics of the Ag alloy film 11 and the Ag alloy sputtering target 20 after the heat treatment.

In a case where the total content of at least one of Sn or Ge is less than 0.5 atom%, the above-described actions and effects may not be achieved. In contrast, in a case where the total content of at least one of Sn or Ge is greater than 8.0 atom%, the hardness of the alloy significantly increases, and cracks frequently occur during rolling or the like, whereby the Ag alloy sputtering target 20 for forming the Ag alloy film 11 may not be produced.

Therefore, in this embodiment, the total content of at least one of Sn or Ge is in a range of 0.5 atom% to 8.0 atom%.

The total content of at least one of Sn or Ge is preferably in a range of 0.5 atom% to 3.0 atom%.

For example, low-emission glass or the like includes tempered glass products that are strengthened by a heat treatment and ordinary glass products that are not heat-treated. By limiting the total content of at least one of Sn or Ge to 3.0 atom% or less, the optical characteristics and the electrical characteristics before the heat treatment can be improved, and tempered glass products and ordinary glass products can be produced without distinction.

(Na, K, Ba, Te)

Na, K, Ba, and Te are elements that have a melting point of 700°C or lower and are not solid-soluted in Ag. Accordingly, in a case where the heat treatment is performed after the film formation, the above-described elements that have been solid-soluted in the mother phase of Ag in the Ag alloy film 11 may be concentrated at crystal grain boundaries and melted during the heating, and thus the characteristics of the Ag alloy film 11 may deteriorate.

Therefore, in this embodiment, the total content of Na, K, Ba, and Te is limited to 50 ppm by mass or less, and the deterioration of the characteristics of the Ag alloy film 11 is suppressed.

(Carbon)

Carbon may be oxidized during the heat treatment and released as a CO gas or a $CO_2$ gas, that may cause unevenness in the Ag alloy film 11.

Accordingly, in this embodiment, the carbon content is limited to 50 ppm by mass or less to suppress the occurrence of unevenness in the Ag alloy film 11 due to the heat treatment or the like.

(At Least One Additive Element Selected from Mg, Ca, and Sb)

The above-described additive elements act to further improve the heat resistance of the Ag alloy.

In a case where a ratio X/Z of X atom% representing a total content of at least one additive element selected from Mg, Ca, and Sb to Z atom% representing a total content of Sn and Ge is less than 0.02, the heat resistance may not be improved by the above-described additive element. In a case where X/Z is greater than 0.4, the heat resistance improving effect of Sn or Ge may be inhibited.

Therefore, in this embodiment, in a case where a total content of one or more additive elements selected from Mg, Ca, and Sb is represented by X atom% and a total content of Sn and Ge is represented by Z atom%, the ratio X/Z is set in a range of 0.02 to 0.4.

In the Ag alloy sputtering target 20 according to this embodiment, an area of a sputtering surface is 0.25 m$^2$ or greater. In addition, an average crystal grain size $\mu_{GS}$ in the sputtering surface is 200 $\mu$m or less, and a distribution $D_{GS}$ defined by the following expression by a standard deviation $\sigma_{GS}$ of the crystal grain size and the average crystal grain size $\mu_{GS}$ is 25% or less. $D_{GS} = (\sigma_{GS}/\mu_{GS}) \times 100$ (%)

In this embodiment, since the sputtering surface has a rectangular shape as shown in Fig. 2, the crystal grain size is measured at 5 positions, that is, the center and 4 corners of the sputtering surface, and from the obtained 5 measured values, the average crystal grain size $\mu_{GS}$ and the standard deviation $\sigma_{GS}$ of the crystal grain size in the sputtering surface of the Ag alloy sputtering target 20 are calculated.

The reasons why the area of the sputtering surface and the crystal grain size in the sputtering surface of the Ag alloy sputtering target 20 are specified as described above will be shown below.

In order to produce glass as a building material, it is necessary to form a multilayer film 10 (Ag alloy film 11) with a relatively large area. Accordingly, the area of the sputtering surface of the Ag alloy sputtering target 20 is preferably 0.25 m$^2$ or greater.

By setting the average crystal grain size $\mu_{GS}$ in the sputtering surface to 200 $\mu$m or less, it is possible to suppress the occurrence of abnormal discharge during sputtering, and it is possible to stably perform the film formation by sputtering.

In a case where a crystal grain size distribution exists in the sputtering surface, a difference in sputtering rate may occur in the sputtering surface in the sputtering performed for a long period of time, and a film thickness distribution may occur in the formed Ag alloy film 11. Therefore, the distribution $D_{GS}$ defined by the standard deviation $\sigma_{GS}$ of the crystal grain size and the average crystal grain size $\mu_{GS}$ is limited to 25% or less.

<Method of Producing Ag Alloy Sputtering Target>

Next, a method of producing the Ag alloy sputtering target 20 according to this embodiment will be described.

First, an Ag material having a purity of 99.9 mass% or greater and auxiliary materials Sn, Ge, Mg, Ca, and Sb having a purity of 99.9 mass% or greater are prepared.

The Ag material is leached with a nitric acid, and electrolytic refining is performed using an electrolytic solution having a predetermined Ag concentration. The total content of Na, K, Ba, and Te is reduced to 50 ppm by mass or less, and the carbon content is reduced to 50 ppm by mass or less.

The Ag material is dissolved under a vacuum atmosphere or an inert gas atmosphere, and a predetermined amount of Sn, Ge, Mg, Ca, and Sb is added to the obtained molten metal to produce an Ag alloy ingot having a predetermined composition. Sn, Ge, Mg, Ca, and Sb are preferably added in a state in which the Ag material is dissolved under a vacuum atmosphere, and then the atmosphere is replaced by an inert gas (Ar). Further, a mother alloy containing the above-described elements may be used as an auxiliary material.

Next, as a homogenization treatment step, the Ag alloy ingot is heat-treated by being held for 1 hour to 10 hours at a temperature of 600°C to 900°C.

In a case where the heat treatment temperature is lower than 600°C or the holding time is shorter than 1 hour, sufficient homogenization may not be achieved. In a case where the heat treatment temperature is higher than 900°C, the temperature approaches the melting point of Ag, and softening and melting may occur. In a case where the holding time is longer than 10 hours, the auxiliary materials in the Ag alloy may be internally oxidized.

Next, hot working is performed. In this embodiment, hot rolling is performed. The rolling finishing temperature is preferably in a range of 500°C to 700°C, and intermediate annealing is preferably performed depending on the circumstances.

At least the working rate (rolling reduction) of the final one pass of rolling is preferably 20% or greater. In a case where the working rate (rolling reduction) is less than 20%, the crystal grain size cannot be sufficiently reduced, and the crystal grain size inside the alloy may be non-uniform. It is realistic that the working rate (rolling reduction) per pass is 50% or less from the relationship with the capacity of the rolling machine.

Next, after the hot rolling, a heat treatment is performed to homogenize the crystal structure of the sputtering target and to remove work hardening. The heat treatment temperature is preferably in a range of 600°C to 750°C, and the holding time is preferably in a range of 1 hour to 5 hours.

In a case where the heat treatment temperature is lower than 600°C, a sufficient work hardening removing effect is not obtained, and in a case where the heat treatment temperature is higher than 750°C, the crystal grains may coarsen. After the heat treatment, rapid cooling is performed by air cooling or water cooling.

The Ag alloy sputtering target 20 according to this embodiment is produced through the above-described steps.

<Method of Producing Multilayer Film>

Next, a method of producing the multilayer film 10 according to this embodiment will be described.

First, the transparent dielectric film 12 is formed on the surface of the glass substrate 1. In this embodiment, the film is formed using a sputtering target made of the above-described oxide or nitride. In consideration of the conductive property of the sputtering target, direct current (DC) sputtering, radio frequency (RF) sputtering, medium frequency (MF) sputtering, alternating current (AC) sputtering, or the like is preferably appropriately selected and used.

The Ag alloy film 11 is formed on the formed transparent dielectric film 12 using the above-described Ag alloy sputtering target 20 according to this embodiment.

The formation of the transparent dielectric film 12 and the Ag alloy film 11 as described above is repeated to form the multilayer film 10 according to this embodiment.

In the multilayer film 10 according to this embodiment having the above configuration, the Ag alloy film 11 contains at least one of Sn or Ge in a range of 0.5 atom% to 8.0 atom% in total, and thus the heat resistance of the Ag alloy film 11 can be improved. Accordingly, it is not required to form a protective film made of a metal.

Since the total content of Na, K, Ba, and Te in the Ag alloy film 11 is limited to 50 ppm by mass or less, it is possible to suppress the concentration of the elements at crystal grain boundaries during the heat treatment, and thus it is possible to suppress a deterioration of the characteristics of the Ag alloy film 11.

Since the carbon content of the Ag alloy film 11 is limited to 50 ppm by mass or less, it is possible to suppress the release of carbon as a CO gas or a $CO_2$ gas during the heat treatment, and thus it is possible to suppress the occurrence of unevenness in the Ag alloy film 11.

Accordingly, even in a case where a heat treatment is performed under a relatively high temperature condition such as 700°C, it is possible to suppress the occurrence of cracks in the Ag alloy film 11, and a multilayer film 10 having excellent optical characteristics and electrical characteristics can be provided.

In the Ag alloy film 11, in a case where the total content of at least one of Sn or Ge is 0.5 atom% to 3.0 atom%, the optical characteristics and the electrical characteristics of the Ag alloy film 11 before the heat treatment can be improved, and tempered glass products and ordinary glass products can be produced without distinction.

In a case where the Ag alloy film 11 further contains one or more additive elements selected from Mg, Ca, and Sb, and a relationship of X atom% representing a total content of the additive element with Z atom% representing a total content of Sn and Ge is in a range of $0.02 \leq X/Z \leq 0.4$, the heat resistance of the Ag alloy film 11 can be further improved.

In this embodiment, since the transparent dielectric film 12 is an oxide film or a nitride film containing at least one selected from Zn, Al, Sn, Ti, Si, Zr, Ta, and In, the transparent dielectric film 12 is excellent in optical characteristics such as visible light transmittance and electrical characteristics, and the optical characteristics and the electrical characteristics of the multilayer film 10 can be improved.

Since the Ag alloy sputtering target 20 according to this embodiment has a composition equivalent to that of the above-described Ag alloy film 11, it is possible to form an Ag alloy film 11 having excellent heat resistance, optical characteristics, and electrical characteristics.

In the Ag alloy sputtering target 20 according to this embodiment, the area of the sputtering surface is 0.25 m$^2$ or greater, and this is relatively large. Thus, the film formation by sputtering can be favorably performed on a large substrate or the like.

Since the Ag alloy sputtering target 20 according to this embodiment has an average crystal grain size $\mu_{GS}$ of 200 $\mu$m or less in the sputtering surface, it is possible to suppress the occurrence of abnormal discharge during sputtering, and it is possible to stably perform the film formation by sputtering.

In the Ag alloy sputtering target 20 according to this embodiment, since the distribution $D_{GS}$ defined by the standard deviation $\sigma_{GS}$ of the crystal grain size and the average crystal grain size $\mu_{GS}$ is 25% or less, it is possible to suppress variations in sputtering rate in the sputtering surface even after the sputtering has proceeded, and it is possible to form an Ag alloy film with little variation in thickness.

Although the embodiments of the present invention have been described as above, the present invention is not limited thereto, and can be appropriately changed without departing from the technical idea of the present invention.

For example, in this embodiment, low-emission glass in which a multilayer film is formed on a glass substrate has been described as an example, but the present invention is not limited thereto. A multilayer film according to this embodiment may be formed on a resin substrate, a resin film, or the like, and the resulting laminate may be used as a transparent conductive wiring film.

In this embodiment, a multilayer film having a five-layer structure including transparent dielectric films with two Ag alloy films formed as shown in Fig. 1 has been described, but the present invention is not limited thereto. A multilayer film having a three-layer structure in which one Ag alloy film is formed and a transparent dielectric film is formed on both surfaces of the Ag alloy film, or a multilayer film in which three or more Ag alloy films are formed and a transparent dielectric film is formed on both surfaces of each Ag alloy film may be provided.

In this embodiment, a transparent dielectric film formed using a sputtering target formed of oxide and nitride has been described, but the present invention is not limited thereto. The transparent dielectric film may be formed by performing reaction sputtering in an oxygen atmosphere or a nitrogen atmosphere using a sputtering target formed of the above-described metal (Zn, Al, Sn, Ti, Si, Zr, Ta, In).

In this embodiment, a sputtering surface having a rectangular shape has been described, but the present invention is not limited thereto. The sputtering surface may be circular, or a cylindrical sputtering target having a cylindrical sputtering surface may be used.

EXAMPLES

Hereinafter, results of experiments for confirmation performed to confirm the effectiveness of the present invention will be described.

Ag materials having a purity of 99.9 mass% or greater were prepared, and in Invention Examples and Comparative Examples 1 to 4, the Ag material was leached with a nitric acid, and then subjected to electrolytic refining using an electrolytic solution having a predetermined Ag concentration.

The Ag material subjected to refining was subjected to impurity analysis and carbon gas analysis by an ICP method, and those with a total content of Na, K, Ba, and Te of 50 ppm by mass or less and a carbon content of 50 ppm by mass or less were used. In Comparative Examples 5 and 6, those not subjected to the above-described electrolytic refining were used. In Comparative Examples 7 and 8, Na, K, and C were appropriately added.

The Ag material was dissolved in a vacuum atmosphere, the atmosphere was replaced by an Ar gas, and then auxiliary materials Sn, Ge, Mg, Ca, and Sb having a purity of 99.9 mass% or greater were added to obtain a molten Ag alloy having a predetermined composition. Then, the molten Ag alloy was cast, and thus an Ag alloy ingot was produced. The obtained Ag alloy ingot was homogenized under conditions of 700°C × 3 hours. After the homogenization treatment, hot rolling was performed. The rolling finishing temperature was 600°C, and the rolling reduction of the final one pass of rolling was 25%. After the hot rolling, a heat treatment was performed under conditions of 600°C × 1 hour.

A plate having a length of 2,000 mm, a width of 200 mm, and a thickness of 8 mm was obtained in the above manner.

In addition, as Invention Example 19, a plate subjected to the post-hot-rolling heat treatment under conditions of 800°C × 3 hours was produced, and as Invention Example 20, a plate subjected to the homogenization treatment under conditions of 600°C × 30 minutes and the post-hot-rolling heat treatment under conditions of 800°C × 10 minutes was produced.

In the obtained plate, an average crystal grain size and a distribution in a sputtering surface were measured as follows.

A measurement sample was collected from the positions shown in Fig. 2. A sputtering surface of each measurement sample was polished by waterproof abrasive paper of #180 to #4000 as an observation surface, and then buffed using abrasive grains of 1 to 3 $\mu$m.

Then, using a mixed liquid of hydrogen peroxide water and ammonia water as an etching liquid, the sample was immersed for 1 to 2 seconds at room temperature in the etching liquid to perform etching of the observation surface.

The observation surface after the etching was photographed by an optical microscope at a magnification of 30 times. In each photograph, a total of four 60 mm-line segments were vertically and horizontally drawn at intervals of 20 mm in a lattice shape, and the number of crystal grains cut by each straight line was counted. The number of crystal grains positioned at an end portion of the line segment was counted as 0.5.

An average cut piece length L ($\mu$m) was calculated by L = 60,000/(M·N). M is actual magnification, and N is the average number of cut crystal grains.

With the average cut piece length L, a crystal grain size d ($\mu$m) of the measurement sample was calculated by d = (3/2) × L.

An average crystal grain size $\mu_{GS}$ and a standard deviation $\sigma_{GS}$ of the crystal grain size of the whole plate were calculated from a 5-point average of the crystal grain sizes obtained from the measurement samples at 5 positions. Using the average crystal grain size $\mu_{GS}$ and the standard deviation $\sigma_{GS}$ of the crystal grain size, a distribution $D_{GS}$ was calculated by the following expression. The measurement results are shown in Table 1.

$$D_{GS} = (\sigma_{GS}/\mu_{GS}) \times 100 \ (\%)$$

Next, the above-described plate was cut and machined to produce an Ag alloy sputtering target having predetermined dimensions (126 mm × 178 mm × thickness 6 mm). Elements such as Na, K, and C exist in sebum and the like in a human body. Accordingly, the Ag alloy sputtering target was not handled with bare hands throughout the production process.

The Ag alloy sputtering target was soldered to a backing plate made of oxygen-free copper, and this was mounted on a sputtering device. In this embodiment, a magnetron DC sputtering device was used. In this embodiment, a substrate transfer type sputtering device was used.

(Abnormal Discharge Frequency)

The above-described target complex was attached to a usual magnetron sputtering device, and after the air was exhausted to 1 × 10⁻⁴ Pa, the sputtering was performed under conditions of Ar gas pressure: 0.5 Pa, input power: DC 1000 W, and distance from target substrate: 60 mm. The abnormal discharge frequency during the sputtering was measured as abnormal discharge frequency for one hour from the start of discharge by an arc count function of a DC power supply (RPDG-50A) manufactured by MKS Instruments.

(In-Plane Variations in Sputtering Rate)

In the plate having the above-described dimensions (2,000 mm × 200 mm × 8 mmt), three Ag alloy sputtering targets having predetermined dimensions (126 mm × 178 mm × 6 mm) were produced from three positions (left end, center, right end) in the longitudinal direction. Each sputtering target was sputtered under the same conditions as in paragraph 0063, and a sputtering rate was calculated. In order to calculate the sputtering rate, a film was formed for a certain period of time on a glass substrate covered with a mask tape for measuring a step, and a step of the formed film was measured using a step measuring device (ULVAC, Inc., DEKTAK-XT). The difference in sputtering rate among the three sputtering targets was calculated by the following expression.

$$\{(\text{Maximum Rate}) - (\text{Minimum Rate})\}/(\text{Average of Rates of 3 Targets}) \times 100$$

$$(\%)$$

Sputtering targets each formed of nitride and oxide shown in Tables 2 and 3 were prepared. In $ZnSnO_X$ used for the first and third layers shown in Tables 2 and 3, the atom ratio of Zn:Sn was 1:1.

On a 5 cm square glass substrate (EAGLE XG glass manufactured by Corning Incorporated), a multilayer film having a layer configuration shown in Tables 2 and 3 was formed by sputtering.

The sputtering conditions for the Ag alloy film were specified as follows.

Vacuum at Which Film Formation is Started: $1.0 \times 10$-4 Pa or less
Sputtering Gas: High-purity argon
Sputtering Gas Pressure in Chamber: 0.5 Pa
Direct Current: 300 W

Multilayer films of Invention Examples and Comparative Examples were formed in the above manner. As a conventional example, a multilayer film having a layer configuration shown in Table 3 was formed.

The multilayer films obtained as described above were heat-treated at 700°C for 5 minutes, and then air-cooled. Sheet resistance, visible light transmittance, and infrared reflectance before and after the heat treatment were measured as follows. In addition, the appearance of the multilayer films after the heat treatment was evaluated.

(Sheet Resistance)

The sheet resistance of the multilayer film was measured by a four probe method using a resistance measuring device (LORESTA GP manufactured by Mitsubishi Chemical Corporation). The evaluation results are shown in Tables 4 and 5.

(Visible Light Transmittance and Infrared Reflectance)

Using a spectrophotometer (U-4100 manufactured by Hitachi High-Technologies Corporation), the transmittance at a wavelength of 550 nm (visible light) and the reflectance at a wavelength of 2,000 nm (infrared rays) were measured. The evaluation results are shown in Tables 4 and 5.

(Observation of Film Appearance)

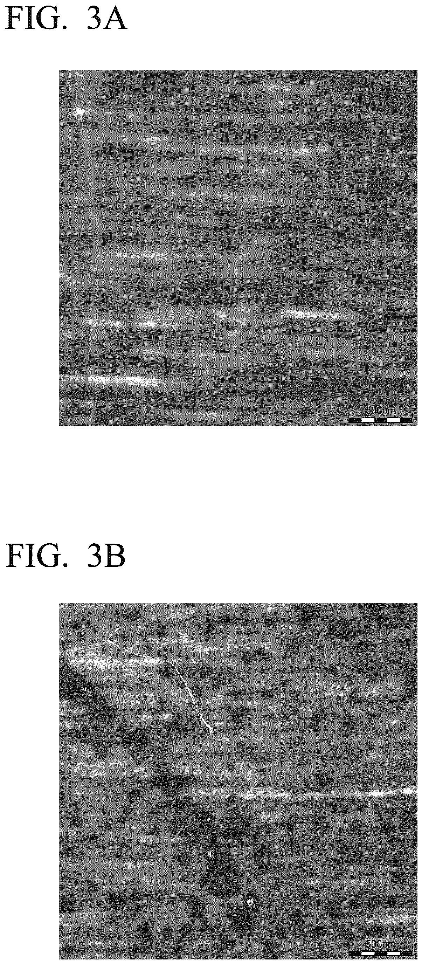

The appearance of the multilayer film after the heat treatment was observed using an optical microscope at an actual magnification of 100 times. Those in which defects of 100 $\mu$m or greater were observed were ranked as "B", and those in which no defects of 100 $\mu$m or greater were observed were ranked as "A". The evaluation results are shown in Table 3. Fig. 3A shows the appearance observation result of Invention Example 3, and Fig. 3A shows the appearance observation result of Comparative Example 1.

[Table 1]

| | | Composition (atom%) | | | | | | Composition Ratio | Impurities (ppm by mass) | | Crystal Grain Size | | Abnormal Discharge Frequency (frequency) | Maximum Difference in Sputtering Rate (%) |
|---|---|---|---|---|---|---|---|---|---|---|---|---|---|---|
| | | Sn | Ge | Ca | Mg | Sb | Ag | X/Z | Na, K, Ba, Te | c | Average $\mu_{GS}$ (μm) | Distribution $D_{GS}$ (%) | | |
| Invention Examples | 1 | 0.5 | - | - | - | - | remainder | - | 8 | 10 | 170 | 11 | 1 | 3 |
| | 2 | 3.0 | - | - | - | - | remainder | - | 7 | 10 | 150 | 20 | 1 | 4 |
| | 3 | 5.0 | - | - | - | - | remainder | - | 6 | 20 | 110 | 12 | 1 | 3 |
| | 4 | 8.0 | - | - | - | - | remainder | - | 3 | 10 | 110 | 13 | 0 | 3 |
| | 5 | - | 0.5 | - | - | - | remainder | - | 2 | 10 | 120 | 15 | 1 | 3 |
| | 6 | - | 3.0 | - | - | - | remainder | - | 2 | 20 | 140 | 17 | 0 | 2 |
| | 7 | - | 5.0 | - | - | - | remainder | - | 4 | 10 | 120 | 14 | 1 | 3 |
| | 8 | - | 8.0 | - | - | - | remainder | - | 2 | 10 | 130 | 13 | 1 | 3 |
| | 9 | 1.0 | 1.0 | - | - | - | remainder | - | 5 | 10 | 120 | 15 | 1 | 2 |
| | 10 | 3.0 | - | 0.2 | - | - | remainder | 0.07 | 6 | 10 | 80 | 17 | 1 | 3 |
| | 11 | 3.0 | - | - | 1.0 | - | remainder | 0.33 | 4 | 20 | 100 | 15 | 0 | 2 |
| | 12 | 3.0 | - | - | - | 0.5 | remainder | 0.17 | 6 | 10 | 90 | 20 | 1 | 3 |
| | 13 | - | 2.0 | 0.1 | - | - | remainder | 0.05 | 2 | 10 | 80 | 17 | 0 | 4 |
| | 14 | - | 3.0 | 0.2 | - | - | remainder | 0.07 | 3 | 10 | 70 | 14 | 0 | 3 |
| | 15 | - | 3.0 | - | 1.0 | - | remainder | 0.33 | 4 | 10 | 140 | 10 | 0 | 3 |
| | 16 | - | 2.0 | - | 0.5 | - | remainder | 0.25 | 4 | 20 | 110 | 14 | 0 | 3 |
| | 17 | - | 3.0 | - | - | 1.0 | remainder | 0.33 | 1 | 20 | 120 | 15 | 0 | 3 |
| | 18 | - | 3.0 | - | - | 0.5 | remainder | 0.17 | 4 | 10 | 90 | 16 | 0 | 3 |
| | 19 | - | 2.0 | 0.1 | - | - | remainder | 0.05 | 3 | 10 | 310 | 16 | 25 | 3 |
| | 20 | - | 2.0 | 0.1 | - | - | remainder | 0.05 | 2 | 10 | 260 | 41 | 22 | 10 |

EP 3 862 459 A1

(continued)

| | | Composition (atom%) | | | | | | Composition Ratio | Impurities (ppm by mass) | | Crystal Grain Size | | Abnormal Discharge Frequency (frequency) | Maximum Difference in Sputtering Rate (%) |
|---|---|---|---|---|---|---|---|---|---|---|---|---|---|---|
| | | Sn | Ge | Ca | Mg | Sb | Ag | $X/Z$ | Na, K, Ba, Te | c | Average $\mu_{GS}$ ($\mu$m) | Distribution $D_{GS}$ (%) | | |
| Comparative Examples | 1 | 0.1 | - | - | - | - | remainder | - | 5 | 10 | 190 | 15 | 1 | 3 |
| | 2 | 10.0 | - | - | - | - | remainder | - | 4 | 10 | Cracks occurred during production. | | | |
| | 3 | - | 0.1 | - | - | - | remainder | - | 4 | 10 | 180 | 22 | 1 | 2 |
| | 4 | - | 10.0 | - | - | - | remainder | - | 5 | 10 | Cracks occurred during production. | | | |
| | 5 | 3.0 | - | - | - | - | remainder | - | 81 | 60 | 120 | 24 | 0 | 4 |
| | 6 | - | 3.0 | - | - | - | remainder | - | 160 | 80 | 140 | 16 | 1 | 3 |
| | 7 | - | 3.0 | - | - | - | remainder | - | 80 | 10 | 150 | 14 | 0 | 3 |
| | 8 | - | 3.0 | - | - | - | remainder | - | 14 | 70 | 110 | 15 | 0 | 3 |
| | 9 | - | 1.0 | 0.5 | - | - | remainder | 0.50 | 4 | 10 | 90 | 20 | 0 | 3 |
| | 10 | - | 3.0 | - | 2.0 | - | remainder | 0.67 | 5 | 10 | 110 | 15 | 1 | 3 |
| | 11 | - | 3.0 | - | - | 3.0 | remainder | 1.00 | 3 | 10 | 100 | 14 | 1 | 3 |

\* Composition Ratio X/Z: A ratio of X atom% of one or more additive elements selected from Mg, Ca, and Sb to a total content Z atom% of Sn and Ge

[Table 2]

| | | Layer Structure of Multilayer Film | | | | | | | | | | |
|---|---|---|---|---|---|---|---|---|---|---|---|---|
| | | First Layer | | Second Layer | | Third Layer | | Fourth Layer | | Fifth Layer | | Sixth Layer | |
| | | Material | Thickness (nm) | Material | Thickness (nm) | Material | Thickness (nm) | Material | Thickness (nm) | Material | Thickness (nm) | Material | Thickness (nm) |
| | 101 | $ZnSnO_X$ | 40 | Invention Example 1 | 18 | $ZnSnO_X$ | 40 | - | - | - | - | - | - |
| | 102 | $ZnSnO_X$ | 40 | Invention Example 2 | 18 | $ZnSnO_X$ | 40 | - | - | - | - | - | - |
| | 103 | $ZnSnO_X$ | 40 | Invention Example 3 | 18 | $ZnSnO_X$ | 40 | - | - | - | - | - | - |
| | 104 | $ZnSnO_X$ | 40 | Invention Example 4 | 18 | $ZnSnO_X$ | 40 | - | - | - | - | - | - |
| | 105 | $ZnSnO_X$ | 40 | Invention Example 5 | 18 | $ZnSnO_X$ | 40 | - | - | - | - | - | - |
| | 106 | $ZnSnO_X$ | 40 | Invention Example 6 | 18 | $ZnSnO_X$ | 40 | - | - | - | - | - | - |
| | 107 | $ZnSnO_X$ | 40 | Invention Example 7 | 18 | $ZnSnO_X$ | 40 | - | - | - | - | - | - |
| | 108 | $ZnSnO_X$ | 40 | Invention Example 8 | 18 | $ZnSnO_X$ | 40 | - | - | - | - | - | - |
| | 109 | $ZnSnO_X$ | 40 | Invention Example 9 | 18 | $ZnSnO_X$ | 40 | - | - | - | - | - | - |
| | 110 | $ZnSnO_X$ | 40 | Invention Example 10 | 18 | $ZnSnO_X$ | 40 | - | - | - | - | - | - |
| | 111 | $ZnSnO_X$ | 40 | Invention Example 11 | 18 | $ZnSnO_X$ | 40 | - | - | - | - | - | - |
| | 112 | $ZnSnO_X$ | 40 | Invention Example 12 | 18 | $ZnSnO_X$ | 40 | - | - | - | - | - | - |
| | 113 | $ZnSnO_X$ | 40 | Invention Example 13 | 18 | $ZnSnO_X$ | 40 | - | - | - | - | - | - |

(continued)

Layer Structure of Multilayer Film

| | | First Layer | | Second Layer | | Third Layer | | Fourth Layer | | Fifth Layer | | Sixth Layer | |
|---|---|---|---|---|---|---|---|---|---|---|---|---|---|
| | | Material | Thickness (nm) | Material | Thickness (nm) | Material | Thickness (nm) | Material | Thickness (nm) | Material | Thickness (nm) | Material | Thickness (nm) |
| Invention Examples | 114 | $ZnSnO_X$ | 40 | Invention Example 14 | 18 | $ZnSnO_X$ | 40 | - | - | - | - | - | - |
| | 115 | $ZnSnO_X$ | 40 | Invention Example 15 | 18 | $ZnSnO_X$ | 40 | - | - | - | - | - | - |
| | 116 | $ZnSnO_X$ | 40 | Invention Example 16 | 18 | $ZnSnO_X$ | 40 | - | - | - | - | - | - |
| | 117 | $ZnSnO_X$ | 40 | Invention Example 17 | 18 | $ZnSnO_X$ | 40 | - | - | - | - | - | - |
| | 118 | $ZnSnO_X$ | 40 | Invention Example 18 | 18 | $ZnSnO_X$ | 40 | - | - | - | - | - | - |
| | 119 | $ZnO_X$ | 40 | Invention Example 13 | 18 | $ZnO_X$ | 40 | - | - | - | - | - | - |
| | 120 | $SnO_X$ | 40 | Invention Example 13 | 18 | $SnO_X$ | 40 | - | - | - | - | - | - |
| | 121 | $AlO_X$ | 40 | Invention Example 13 | 18 | $AlO_X$ | 40 | - | - | - | - | - | - |
| | 122 | $AlN_X$ | 40 | Invention Example 13 | 18 | $AlN_X$ | 40 | - | - | - | - | - | - |
| | 123 | $TiO_X$ | 40 | Invention Example 13 | 18 | $TiO_X$ | 40 | - | - | - | - | - | - |
| | 124 | $SiN_X$ | 40 | Invention Example 13 | 18 | $SiN_X$ | 40 | - | - | - | - | - | - |
| | 125 | $ZrO_X$ | 40 | Invention Example 13 | 18 | $ZrO_X$ | 40 | - | - | - | - | - | - |
| | 126 | $TaO_X$ | 40 | Invention Example 13 | 18 | $TaO_X$ | 40 | - | - | - | - | - | - |

(continued)

| | | First Layer | | Second Layer | | Third Layer | | Fourth Layer | | Fifth Layer | | Sixth Layer | |
| | | Material | Thickness (nm) | Material | Thickness (nm) | Material | Thickness (nm) | Material | Thickness (nm) | Material | Thickness (nm) | Material | Thickness (nm) |
|---|---|---|---|---|---|---|---|---|---|---|---|---|---|
| | 127 | InSnO$_X$ | 40 | Invention Example 13 | 18 | InSnO$_X$ | 40 | - | - | - | - | - | - |
| | 128 | ZnSnO$_X$ | 40 | Invention Example 13 | 11 | ZnSnO$_X$ | 80 | Invention Example 13 | 14 | ZnSnO$_X$ | 40 | - | - |

[Table 3]

| | | \multicolumn{12}{c}{Layer Structure of Multilayer Film} |
| | | First Layer | | Second Layer | | Third Layer | | Fourth Layer | | Fifth Layer | | Sixth Layer | |
| | | Material | Thickness (nm) | Material | Thickness (nm) | Material | Thickness (nm) | Material | Thickness (nm) | Material | Thickness (nm) | Material | Thickness (nm) |
|---|---|---|---|---|---|---|---|---|---|---|---|---|---|
| Comparative Examples | 101 | $ZnSnO_X$ | 40 | Comparative Example 1 | 18 | $ZnSnO_X$ | 40 | - | - | - | - | - | - |
| | 103 | $ZnSnO_X$ | 40 | Comparative Example 3 | 18 | $ZnSnO_X$ | 40 | - | - | - | - | - | - |
| | 105 | $ZnSnO_X$ | 40 | Comparative Example 5 | 18 | $ZnSnO_X$ | 40 | - | - | - | - | - | - |
| | 106 | $ZnSnO_X$ | 40 | Comparative Example 6 | 18 | $ZnSnO_X$ | 40 | - | - | - | - | - | - |
| | 107 | $ZnSnO_X$ | 40 | Comparative Example 7 | 18 | $ZnSnO_X$ | 40 | - | - | - | - | - | - |
| | 108 | $ZnSnO_X$ | 40 | Comparative Example 8 | 18 | $ZnSnO_X$ | 40 | - | - | - | - | - | - |
| | 109 | $ZnSnO_X$ | 40 | Comparative Example 9 | 18 | $ZnSnO_X$ | 40 | - | - | - | - | - | - |
| | 110 | $ZnSnO_X$ | 40 | Comparative Example 10 | 18 | $ZnSnO_X$ | 40 | - | - | - | - | - | - |
| | 111 | $ZnSnO_X$ | 40 | Comparative Example 11 | 18 | $ZnSnO_X$ | 40 | - | - | - | - | - | - |
| Conventional Example | | $SnO_2$ | 32 | ZnO·Al | 5 | pure Ag | 10 | Zn·Al | 2 | ZnO·Al | 10 | $SnO_2$ | 25 |

[Table 4]

| | | Before Heat Treatment | | | After Heat Treatment | | | |
|---|---|---|---|---|---|---|---|---|
| | | Sheet Resistance (Ω/□) | Visible Light Transmittance (%) | Infrared Reflectance (%) | Sheet Resistance (Ω/□) | Visible Light Transmittance (%) | Infrared Reflectance (%) | Appearance Observation |
| Invention Examples | 101 | 3.5 | 76.9 | 90.0 | 2.4 | 81.5 | 91.0 | A |
| | 102 | 6.6 | 73.4 | 89.5 | 2.2 | 82.0 | 91.0 | A |
| | 103 | 9.6 | 68.6 | 86.5 | 2.1 | 82.1 | 92.0 | A |
| | 104 | 12.1 | 66.7 | 85.4 | 2.1 | 82.3 | 92.1 | A |
| | 105 | 3.3 | 77.0 | 90.1 | 2.5 | 81.6 | 91.7 | A |
| | 106 | 5.9 | 74.8 | 89.7 | 2.3 | 82.1 | 91.6 | A |
| | 107 | 9.0 | 69.1 | 86.2 | 2.0 | 82.3 | 91.4 | A |
| | 108 | 11.5 | 67.8 | 85.8 | 2.0 | 82.4 | 92.0 | A |
| | 109 | 4.5 | 75.0 | 90.0 | 2.3 | 82.0 | 92.0 | A |
| | 110 | 6.6 | 73.4 | 87.0 | 2.2 | 83.0 | 92.1 | A |
| | 111 | 6.8 | 73.1 | 86.9 | 2.1 | 82.9 | 92.4 | A |
| | 112 | 6.9 | 73.5 | 87.5 | 2.1 | 83.1 | 92.4 | A |
| | 113 | 4.7 | 75.4 | 88.3 | 2.2 | 83.0 | 92.4 | A |
| | 114 | 6.0 | 74.5 | 89.0 | 2.2 | 83.2 | 92.0 | A |
| | 115 | 6.5 | 74.7 | 88.1 | 2.1 | 83.4 | 92.1 | A |
| | 116 | 5.9 | 75.3 | 88.3 | 2.2 | 83.5 | 92.4 | A |
| | 117 | 6.7 | 74.6 | 88.3 | 2.4 | 83.4 | 92.3 | A |
| | 118 | 6.4 | 74.2 | 88.4 | 2.2 | 83.3 | 92.1 | A |
| | 119 | 4.6 | 74.4 | 88.2 | 2.1 | 81.9 | 92.2 | A |
| | 120 | 4.8 | 70.1 | 88.3 | 2.4 | 82.0 | 92.4 | A |
| | 121 | 4.5 | 70.0 | 88.4 | 2.2 | 84.0 | 92.2 | A |
| | 122 | 4.7 | 75.9 | 88.3 | 2.3 | 83.4 | 92.2 | A |
| | 123 | 4.9 | 77.1 | 88.4 | 2.1 | 84.0 | 92.2 | A |

(continued)

| | | Before Heat Treatment | | | After Heat Treatment | | | |
|---|---|---|---|---|---|---|---|---|
| | | Sheet Resistance ($\Omega/\square$) | Visible Light Transmittance (%) | Infrared Reflectance (%) | Sheet Resistance ($\Omega/\square$) | Visible Light Transmittance (%) | Infrared Reflectance (%) | Appearance Observation |
| | 124 | 5.0 | 76.8 | 88.3 | 2.3 | 83.8 | 92.1 | A |
| | 125 | 5.1 | 76.4 | 88.3 | 2.4 | 83.7 | 92.1 | A |
| | 126 | 5.1 | 76.7 | 88.3 | 2.3 | 83.8 | 92.3 | A |
| | 127 | 4.7 | 78.0 | 88.4 | 2.2 | 83.9 | 92.0 | A |
| | 128 | 2.1 | 82.0 | 91.5 | 1.5 | 85.1 | 93.6 | A |

[Table 5]

| | | Before Heat Treatment | | | After Heat Treatment | | | |
|---|---|---|---|---|---|---|---|---|
| | | Sheet Resistance ($\Omega/\square$) | Visible Light Transmittance (%) | Infrared Reflectance (%) | Sheet Resistance ($\Omega/\square$) | Visible Light Transmittance (%) | Infrared Reflectance (%) | Appearance Observation |
| Comparative Examples | 101 | 3.1 | 77.1 | 90.0 | 5.0 | 75.2 | 84.1 | B |
| | 103 | 3.0 | 77.3 | 90.1 | 5.2 | 74.3 | 83.2 | B |
| | 105 | 6.7 | 73.5 | 89.4 | 10.2 | 64.1 | 80.1 | B |
| | 106 | 6.3 | 75.1 | 89.5 | 9.8 | 63.1 | 80.0 | B |
| | 107 | 6.4 | 75.3 | 89.5 | 10.2 | 70.0 | 83.2 | B |
| | 108 | 6.3 | 75.1 | 89.6 | 9.9 | 68.6 | 81.6 | B |
| | 109 | 3.7 | 76.5 | 89.7 | 4.5 | 66.6 | 81.4 | B |
| | 110 | 6.9 | 73.9 | 88.4 | 7.0 | 68.0 | 81.3 | B |
| | 111 | 10.0 | 72.1 | 87.5 | 10.1 | 68.2 | 82.0 | B |
| Conventional Example | | 6.6 | 78.1 | 81.0 | 6.8 | 74.1 | 80.0 | B |

The multilayer films of Comparative Examples 101 and 103 using the Ag alloy sputtering targets of Comparative Examples 1 and 3, respectively, in which the total content of at least one of Sn or Ge was less than 0.5 atom% were confirmed to deteriorate in sheet resistance after the heat treatment, visible light transmittance, and infrared reflectance. In addition, the appearance of the multilayer film after the heat treatment was evaluated as "B".

In Comparative Examples 2 and 4 in which the total content of at least one Sn or Ge was greater than 8.0 atom%, cracks occurred during the production of the target, and thus it was not possible to produce the Ag alloy sputtering target. Therefore, the subsequent evaluation was stopped.

The multilayer films of Comparative Examples 105 to 108 formed using the Ag alloy sputtering targets of Comparative Examples 5 and 6 in which the total content of Na, K, Ba, and Te was greater than 50 ppm by mass and the carbon content was greater than 50 ppm by mass, Comparative Example 7 in which the total content of Na, K, Ba, and Te was greater than 50 ppm by mass, and Comparative Example 8 in which the carbon content was greater than 50 ppm by mass, respectively, were confirmed to deteriorate in sheet resistance after the heat treatment, visible light transmittance, and infrared reflectance. In addition, the appearance of the multilayer film after the heat treatment was evaluated as "B".

The multilayer films of Comparative Examples 109 to 111 formed using the Ag alloy sputtering targets of Comparative Examples 9 to 11 in which the ratio X/Z of the total content X atom% of one or more additive elements selected from Mg, Ca, and Sb to the total content Z atom% of Sn and Ge was greater than 0.5, respectively, were confirmed to deteriorate in sheet resistance after the heat treatment, visible light transmittance, and infrared reflectance. In addition, the appearance of the multilayer film after the heat treatment was evaluated as "B".

In contrast, the multilayer films of Invention Examples 101 to 128 formed using the Ag alloy sputtering targets of Invention Examples 1 to 18, respectively, were confirmed to be excellent in sheet resistance after the heat treatment, visible light transmittance, and infrared reflectance. In addition, the appearance of the multilayer film after the heat treatment was evaluated as "A". Furthermore, the multilayer films of Invention Examples 113 and 119 to 128 formed using the Ag alloy sputtering target of Invention Example 13 were confirmed to be excellent in sheet resistance after the heat treatment, visible light transmittance, and infrared reflectance even in a case where the material of the transparent dielectric film was changed or in a case where the layer structure was a five-layer structure. Moreover, in Invention Examples 1 to 18 in which the average crystal grain size $\mu_{GS}$ in the sputtering surface was 200 $\mu$m or less and the distribution $D_{GS}$ was 25% or less, the abnormal discharge frequency was low, and the in-plane difference in sputtering rate was small.

From the above, it has been confirmed that according to Invention Examples, it is possible to provide a multilayer film having excellent heat resistance, optical characteristics, and electrical characteristics, and an Ag alloy sputtering target that is used in the formation of an Ag alloy film constituting the multilayer film.

INDUSTRIAL APPLICABILITY

It is possible to provide a multilayer film having excellent heat resistance, optical characteristics, and electrical characteristics, and an Ag alloy sputtering target that is used in the formation of an Ag alloy film constituting the multilayer film.

REFERENCE SIGNS LIST

10     Multilayer film
11     Ag alloy film
12     Transparent dielectric film
20     Ag alloy sputtering target

**Claims**

1. A multilayer film comprising:

    an Ag alloy film; and
    a transparent dielectric film laminated on both surfaces of the Ag alloy film,
    wherein the Ag alloy film has a composition in which at least one of Sn or Ge is contained in a range of 0.5 atom% to 8.0 atom% in total, a total content of Na, K, Ba, and Te is 50 ppm by mass or less, a carbon content is 50 ppm by mass or less, and a remainder contains Ag and unavoidable impurities.

2. The multilayer film according to claim 1,
   wherein the Ag alloy film contains at least one of Sn or Ge in a range of 0.5 atom% to 3.0 atom% in total.

3. The multilayer film according to claim 1 or 2,
   wherein the Ag alloy film further contains at least one additive element selected from Mg, Ca, and Sb, and
   in a case where a total content of the additive element is represented by X atom% and a total content of Sn and Ge is represented by Z atom%, a ratio X/Z is in a range of $0.02 \leq X/Z \leq 0.4$.

4. The multilayer film according to any one of claims 1 to 3,
   wherein the transparent dielectric film is an oxide film or a nitride film containing at least one selected from Zn, Al, Sn, Ti, Si, Zr, Ta, and In.

5. An Ag alloy sputtering target having a composition in which at least one of Sn or Ge is contained in a range of 0.5 atom% to 8.0 atom% in total, a total content of Na, K, Ba, and Te is 50 ppm by mass or less, a carbon content is 50 ppm by mass or less, and a remainder contains Ag and unavoidable impurities.

6. The Ag alloy sputtering target according to claim 5,
   wherein at least one of Sn or Ge is contained in a range of 0.5 atom% to 3.0 atom% in total.

7. The Ag alloy sputtering target according to claim 5 or 6,
   wherein at least one additive element selected from Mg, Ca, and Sb is further contained, and
   in a case where a total content of the additive element is represented by X atom% and a total content of Sn and Ge is represented by Z atom%, a ratio X/Z is in a range of $0.02 \leq X/Z \leq 0.4$.

8. The Ag alloy sputtering target according to any one of claims 5 to 7,
   wherein an area of a sputtering surface is 0.25 m$^2$ or greater, an average crystal grain size $\mu_{GS}$ in the sputtering surface is 200 $\mu$m or less, and a distribution $D_{GS}$ defined by the following expression by a standard deviation $\sigma_{GS}$ of the crystal grain size and the average crystal grain size $\mu_{GS}$ is 25% or less.

$$D_{GS} = (\sigma_{GS}/\mu_{GS}) \times 100 \ (\%)$$

# FIG. 1

# FIG. 2

FIG. 3A

FIG. 3B

## INTERNATIONAL SEARCH REPORT

| International application No. |
|---|
| PCT/JP2018/037025 |

A. CLASSIFICATION OF SUBJECT MATTER

Int. Cl. C23C14/06(2006.01)i, B32B9/00(2006.01)i, B32B15/04(2006.01)i,
C03C17/36(2006.01)i, C23C14/08(2006.01)i, C23C14/34(2006.01)i

According to International Patent Classification (IPC) or to both national classification and IPC

B. FIELDS SEARCHED

Minimum documentation searched (classification system followed by classification symbols)
Int. Cl. C23C14/06, B32B9/00, B32B15/04, C03C17/36, C23C14/08, C23C14/34

Documentation searched other than minimum documentation to the extent that such documents are included in the fields searched
Published examined utility model applications of Japan    1922-1996
Published unexamined utility model applications of Japan  1971-2018
Registered utility model specifications of Japan          1996-2018
Published registered utility model applications of Japan  1994-2018

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-002929 A (FURUYA KINZOKU KK) 08 January 2004, claims, paragraphs [0160], [0161], [0189], [0265], [0267], [0335], [0363]-[0381] (Family: none) | 1-8 |
| Y | JP 2005-330549 A (HITACHI METALS, LTD.) 02 December 2005, paragraph [0019] (Family: none) | 1-8 |
| Y | JP 7-003363 A (MITSUBISHI MATERIALS CORP.) 06 January 1995, paragraphs [0006], [0007], [0024], [0025], [0032] & US 5612133 A, description, column 1, line 66 to column 2, line 8, column 3, lines 16-32 & EP 898651 A1 | 3, 7 |

☒ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10.11.2018 | 27.11.2018 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

| International application No. |
| --- |
| PCT/JP2018/037025 |

C (Continuation).    DOCUMENTS CONSIDERED TO BE RELEVANT

| Category* | Citation of document, with indication, where appropriate, of the relevant passages | Relevant to claim No. |
| --- | --- | --- |
| E, X | JP 2018-176493 A (MITSUBISHI MATERIALS CORP.) 15 November 2018, claims, paragraphs [0054]-[0079], fig. 1 (Family: none) | 1-8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017076938 A
- JP 2007070146 A
- JP H09232278 A
- JP 2004238648 A
- JP 2006240289 A